# EUROPÄISCHE PATENTSCHRIFT

(11) **EP 3 075 017 B1**
(45) Veröffentlichungstag und Bekanntmachung des Hinweises auf die Patenterteilung: **06.10.2021**
(21) Anmeldenummer: 14805549.4
(22) Anmeldetag: 26.11.2014
(51) Int. Cl.: H01L 51/52

(54) **ELEKTRONISCHES BAUTEIL**
ELECTRONIC COMPONENT
COMPOSANT ÉLECTRONIQUE

(30) Priorität: 28.11.2013 DE 102013113190
(43) Veröffentlichungstag der Anmeldung: 05.10.2016
(73) Patentinhaber: OSRAM OLED GmbH, 93055 Regensburg (DE)
(72) Erfinder: HÖFLING, Egbert, 93049 Regensburg (DE); SCHICKTANZ, Simon, 93049 Regensburg (DE)
(74) Vertreter: Epping - Hermann - Fischer
(86) Internationale Anmeldenummer: PCT/EP2014/075668
(87) Internationale Veröffentlichungsnummer: WO 2015/078914

(56) Entgegenhaltungen:
- EP-A1- 2 282 360
- WO-A1-2012/133807
- WO-A2-2011/073189
- US-A1- 2006 087 224

## Beschreibung

Es wird ein elektronisches Bauteil angegeben.

Die Druckschrift DE 10 2011 076 733 A1 beschreibt ein elektronisches Bauteil.

Die Druckschrift WO 2011/073189 A2 beschreibt eine großflächige lichtemittierende Vorrichtung mit organischen Leuchtdioden.

Die Druckschrift EP 2 282 360 A1 beschreibt ein optoelektrisches Dünnfilmbauelement.

Die Druckschrift US 2006/087224 A1 beschreibt ein organisches elektrolumineszierendes lichtemittierendes Bauelement.

Eine zu lösende Aufgabe besteht darin, ein elektronisches Bauteil anzugeben, das besonders vielseitig einsetzbar ist.

Die Aufgabe wird durch ein elektronisches Bauteil gemäß Anspruch 1 gelöst.

Gemäß zumindest einer Ausführungsform des elektronischen Bauteils umfasst das elektronische Bauteil einen Anschlussträger. Der Anschlussträger umfasst eine Deckfläche, eine der Deckfläche gegenüberliegende Bodenfläche sowie Seitenflächen, welche die Deckfläche und die Bodenfläche miteinander verbinden. Der Anschlussträger umfasst weiter eine erste elektrische Anschlussstelle und eine zweite elektrische Anschlussstelle. Über die Anschlussstellen des Anschlussträgers ist es möglich, das elektronische Bauteil von außerhalb des elektronischen Bauteils zu kontaktieren. Das heißt, das elektronische Bauteil ist über die elektrischen Anschlussstellen von außen kontaktierbar.

Bei dem Anschlussträger handelt es sich insbesondere um die mechanisch stützende und tragende Komponente des elektronischen Bauteils. Das heißt, insbesondere auf der Deckfläche des Anschlussträgers sind die Komponenten des elektronischen Bauteils angeordnet, die vom Anschlussträger mechanisch gestützt, getragen und zusammengehalten werden. Der Anschlussträger kann beispielsweise nach Art einer Platte ausgebildet sein, das heißt die laterale Ausdehnung des Anschlussträgers in seiner Haupterstreckungsrichtung ist groß gegen die vertikale Ausdehnung des Anschlussträgers senkrecht zu seiner Haupterstreckungsebene. Der Anschlussträger kann beispielsweise eine rechteckige Grundfläche aufweisen.

Gemäß zumindest einer Ausführungsform des elektronischen Bauteils umfasst das elektronische Bauteil einen organischen, aktiven Bereich, der zum Beispiel zur Erzeugung und/oder zum Empfangen von elektromagnetischer Strahlung vorgesehen ist. Beispielsweise kann es sich bei dem elektronischen Bauteil dann um ein optoelektronisches Bauteil, wie eine organische Leuchtdiode (OLED) und/oder um eine organische Fotodiode handeln. Ferner ist es möglich, dass es sich beim elektronischen Bauteil um einen elektronischen Mikrocontroller oder eine anders organisches Leistungsbauteil handelt.

Der Anschlussträger kann ein Substrat des elektronischen Bauteils darstellen. Das heißt, die Komponenten des elektronischen Bauteils, insbesondere der organische, aktive Bereich und Elektroden zur Kontaktierung des organischen, aktiven Bereichs, sind direkt auf den Anschlussträger aufgebracht, beispielsweise sind die Komponenten des elektronischen Bauteils an der Deckfläche des Anschlussträger direkt auf dem Anschlussträger erzeugt. Der Anschlussträger stellt dann die einzige mechanisch stützende Komponente des elektronischen Bauteils dar und der organische, aktive Bereich ist nicht auf ein weiteres Substrat aufgebracht.

Gemäß zumindest einer Ausführungsform des elektronischen Bauteils umfasst das Bauteil eine erste Elektrode, die den aktiven Bereich und die erste elektrische Anschlussstelle elektrisch leitend miteinander verbindet. Beispielsweise kann die erste Elektrode direkt an die erste elektrische Anschlussstelle und den aktiven Bereich angeschlossen sein. Die erste Elektrode kann zumindest stellenweise strahlungsdurchlässig oder strahlungsreflektierend ausgebildet sein. Die erste Elektrode kann dazu mit einem Metall und/oder einem transparenten leitfähigen Oxid wie beispielsweise ITO (Indium Thin Oxide - Indiumzinnoxid) gebildet sein. Die erste Elektrode kann mit dem organischen, aktiven Bereich insbesondere großflächig in Kontakt stehen. Das heißt, die erste Elektrode kann eine Deckfläche oder eine Bodenfläche des aktiven Bereichs großflächig bedecken. Beispielsweise bedeckt die erste Elektrode wenigstens 50 %, insbesondere wenigstens 75 % einer Deckfläche oder einer Bodenfläche des aktiven Bereichs. Die Deckfläche und die Bodenfläche des aktiven Bereichs können dabei im Rahmen der Herstellungstoleranz parallel zur Deckfläche des Anschlussträgers angeordnet sein. Die erste Elektrode kann die Deckfläche oder die Bodenfläche des aktiven Bereichs insbesondere auch vollständig bedecken. Ferner ist es möglich, dass die erste Elektrode mit mehreren Materialien gebildet sein kann, so kann die erste Elektrode beispielsweise mit einem transparenten leitfähigen Oxid und einem Metall gebildet sein. Die erste Elektrode kann mit dem Anschlussträger an dessen Deckfläche stellenweise in direktem Kontakt stehen.

Gemäß zumindest einer Ausführungsform des elektronischen Bauteils umfasst das elektronische Bauteil eine Verkapselungsschicht, die den aktiven Bereich vor Feuchtigkeit und atmosphärischen Gasen schützt. Bei der Verkapselungsschicht kann es sich beispielsweise um eine so genannte Dünnfilmverkapselung handeln. Die Verkapselungsschicht kann durch Abscheideverfahren wie die chemische Gasphasenabscheidung, die physikalische Gasphasenabscheidung, Sputtern, Atomlagenabscheidung (ALD - Atomic Layer Deposition) oder andere Abscheidemethoden erzeugt sein. Insbesondere kann die Verkapselungsschicht wenigstens eine ALD (Atomic Layer Deposition, Atom-Lagen-Abscheidung) -Schicht umfassen, die mit einem ALD-Verfahren hergestellt ist. Das heißt, zumindest diese Verkapselungsschicht ist mittels eines ALD-Verfahrens gebildet.

Mittels eines ALD-Verfahrens können sehr dünne Schichten erzeugt werden, die eine polykristalline oder amorphe Struktur aufweisen. Da eine mittels ALD hergestellte Schicht proportional zur Zahl der Reaktionszyklen, mit denen die Schicht hergestellt wird, wächst, ist eine exakte Steuerung der Schichtdicke möglich. Mittels des ALD-Verfahrens lassen sich besonders gleichmäßige Schichten, das heißt Schichten besonders gleichmäßiger Dicke, herstellen. Ferner erhält man durch das Monolagen-Wachstum mit dem ALD-Verfahren sehr dichte und kristallbaufehlerarme Schichten.

Mit anderen Worten ist zumindest eine Verkapselungsschicht mithilfe eines ALD-Prozesses wie Flash-ALD, photoinduzierte ALD oder eines anderen ALD-Verfahrens abgeschieden.

Eine mittels eines ALD-Verfahrens hergestellte Verkapselungsschicht ist über elektromikroskopische Untersuchungen und andere Analysemethoden der Halbleitertechnik eindeutig von Schichten unterscheidbar, die über alternative Verfahren wie beispielsweise herkömmliche CVD (Chemical Vapor Deposition, chemische Dampfphasenabscheidung) hergestellt sind. Bei dem Merkmal, wonach die Verkapselungsschicht eine ALD-Schicht ist, handelt es sich daher um ein gegenständliches Merkmal, das am fertigen elektronischen Halbleiterchip nachweisbar ist.

Die Verkapselungsschicht, die eine ALD-Schicht ist, ist mit einem elektrisch isolierenden Material gebildet und weist beispielsweise eine Dicke zwischen 0,05 nm und höchstens 500 nm, insbesondere zwischen wenigstens 30 nm und höchstens 50 nm, zum Beispiel eine Dicke von 40 nm auf. Die Verkapselungsschicht kann dabei eine Vielzahl von Unterschichten umfassen, die aufeinander angeordnet sind. Die Verkapselungsschicht enthält oder besteht beispielsweise aus einem der folgenden Materialien: Al₂O₃, SiO₂, SiN. Dabei ist es insbesondere auch möglich, dass die Verkapselungsschicht, die eine ALD-Schicht ist, eine Kombination dieser Materialien enthält.

Die Verkapselungsschicht hemmt den Durchtritt von Feuchtigkeit und/oder atmosphärischen Gasen aus der Umgebung des elektronischen Bauteils durch die Verkapselungsschicht zum organischen, aktiven Bereich hin. Die Verkapselungsschicht ist dazu um den aktiven Bereich herum angeordnet. Beispielsweise ist der aktive Bereich dann vollständig durch die Verkapselungsschicht und eine weitere Komponente des elektronischen Bauteils, zum Beispiel den Anschlussträger, von der Umgebung abgeschlossen. Die Verkapselungsschicht kann dabei auch weitere Komponenten des elektronischen Bauteils, wie zum Beispiel die erste Elektrode oder weitere Elektroden überdecken. Die Verkapselungsschicht kann sich insbesondere mit Komponenten des elektronischen Bauteils, wie beispielsweise dem aktiven Bereich oder Elektroden des elektronischen Bauteils stellenweise in direktem Kontakt befinden.

Die Verkapselungsschicht ist zumindest teilweise durchlässig für die im aktiven Bereich zu emittierende oder zu detektierende elektromagnetische Strahlung ausgebildet. Die Verkapselungsschicht kann dabei zum Beispiel klarsichtig, transparent ausgebildet sein.

Gemäß zumindest einer Ausführungsform des elektronischen Bauteils steht die Verkapselungsschicht stellenweise mit dem Anschlussträger in direktem Kontakt. Das heißt, die Verkapselungsschicht bedeckt den Anschlussträger stellenweise direkt, so dass die übrigen Komponenten des elektronischen Bauteils sämtlich zwischen Anschlussträger und der Verkapselungsschicht angeordnet sein können, so dass die Verkapselungsschicht gemeinsam mit dem Anschlussträger eine Umhüllung für die verbleibenden Komponenten des elektronischen Bauteils darstellen kann.

Erfindungsgemäß umfasst das Bauteil einen Anschlussträger mit einer Deckfläche und einer ersten elektrischen Anschlussstelle sowie einer zweiten elektrischen Anschlussstelle. Das elektronische Bauteil umfasst weiter einen organischen, aktiven Bereich, der zum Beispiel zur Erzeugung und/oder zum Empfangen von elektromagnetischer Strahlung vorgesehen ist und der an der Deckfläche des Anschlussträgers angeordnet ist. Weiter umfasst das elektronische Bauteil eine erste Elektrode, die den aktiven Bereich und die erste elektrische Anschlussstelle elektrisch leitend miteinander verbindet sowie eine Verkapselungsschicht, die den aktiven Bereich vor Feuchtigkeit und atmosphärischen Gasen schützt. Dabei ist das elektronische Bauteil über die elektrischen Anschlussstellen des Anschlussträgers von außen kontaktierbar und die Verkapselungsschicht steht stellenweise mit dem Anschlussträger in direktem Kontakt.

Bei einem hier beschriebenen elektronischen Bauteil stellt der Anschlussträger, der die elektrischen Anschlussstellen zur Kontaktierung des elektronischen Bauteils von außerhalb aufweist, den Träger für den organischen, aktiven Bereich dar. Die Komponenten des elektronischen Bauteils können insbesondere direkt auf den Anschlussträger aufgebracht sein, so dass der Anschlussträger das Substrat für die Elektroden und den organischen, aktiven Bereich darstellt. Das heißt, das elektronische Bauteil kann direkt auf dem Träger prozessiert werden, über den auch der elektrische Kontakt zum Betreiben der Komponenten des elektronischen Bauteils hergestellt wird.

Das elektronische Bauteil weist eine Verkapselungsschicht auf, die den aktiven Bereich vor Feuchtigkeit und atmosphärischen Gasen schützt, wobei die elektrischen Anschlussstellen des elektronischen Bauteils während der Herstellung des elektronischen Bauteils frei von dieser Verkapselungsschicht bleiben. Das heißt, zum Anschließen des elektronischen Bauteils muss die Verkapselungsschicht nicht geöffnet werden, sondern die elektrischen Anschlussstellen bleiben von der Verkapselungsschicht unbedeckt.

Die elektrischen Anschlussstellen können dabei in unterschiedlicher Weise am Anschlussträger ausgebildet sein, so dass ein besonders vielseitiger Einsatz des elektronischen Bauteils möglich ist.

Hier beschriebene elektronische Bauteile, die insbesondere einen organischen, aktiven Bereich umfassen, benötigen eine elektrische und mechanische Verbindung zu dem System, in dem sie betrieben werden. Eine hohe Bauteileffizienz sowie stabile elektro-optische Eigenschaften erfordern eine elektrische Verbindung mit einem niedrigen und dauerhaft stabilen elektrischen Widerstand. Die mechanische Verbindung sollte Belastungen wie Zug-, Druck- und Scherkräften oder Vibrationen standhalten, ohne dass sich die Verbindung zum System oder innerhalb des Bauteils löst.

Dabei hat sich gezeigt, dass insbesondere die Verwendung eines Anschlussträgers als mechanisch stützende und tragende Komponente des elektronischen Bauteils eine einfache Handhabung und eine besonders einfache und kostengünstige Systemintegration des elektronischen Bauteils ermöglicht. Dazu können die Anschlussstellen beispielsweise in der Form von Steckkontakten oder SMT-Kontakten ausgebildet werden. Die elektrischen und mechanischen Verbindungsfunktionen sind damit besonders kostengünstig realisiert.

Ferner kann bei einem hier beschriebenen elektronischen Bauteil der Anteil der nicht aktiven Fläche im Bauteil sehr klein gehalten werden. Dazu kann der organische, aktive Bereich eine Querschnittsfläche aufweisen, die wenigstens 75 %, bevorzugt wenigstens 85 % der Deckfläche des Anschlussträgers entspricht. Das heißt, fast die gesamte Deckfläche des Anschlussträgers kann mit dem aktiven Bereich belegt sein, so dass der Anteil der nicht aktiven Fläche im Bauteil sehr gering ist.

Ferner sind bei einem hier beschriebenen elektronischen Bauteil die Anschlussstellen in den Anschlussträger integriert und werden nicht nachträglich durch Techniken wie Bonden, Löten, Schweißen oder Kleben angebracht. Dadurch ist der Widerstand zwischen der Anschlussstelle und den Elektroden für den organischen, aktiven Bereich vorliegend reduziert.

Da die Anschlussstellen bei der Herstellung des elektronischen Bauteils zu jeder Zeit frei von der Verkapselungsschicht bleiben, muss die Verkapselung vor einem Messverfahren, zur Bestimmung der elektronischen Eigenschaften des Bauteils und/oder vor dem Anschluss des Bauteils nicht entfernt werden oder durchstoßen werden. Da ein Entfernen der Verkapselungsschicht oder ein Durchstoßen der Verkapselungsschicht mit höheren Prozesskosten und Ausbeuteverlusten verbunden ist, da die organischen Schichten und/oder die Verkapselungsschicht geschädigt werden kann und/oder können und eine elektro-optische Charakterisierung des Bauteils im Fertigungsprozess durch ein vorheriges Entfernen oder Durchstoßen der Verkapselungsschicht verzögert ist, zeichnet sich ein hier beschriebenes elektronisches Bauteil durch eine besonders hohe Wirtschaftlichkeit in der Herstellung aus.

Erfindungsgemäß ist der Anschlussträger mit wenigstens zwei elektrisch leitenden Vollkörpern gebildet, die durch zumindest ein elektrisch isolierendes Verbindungselement miteinander verbunden sind. Der Anschlussträger umfasst also mindestens zwei elektrisch leitende Elemente, die Vollkörper. Die elektrisch leitenden Vollkörper sind lateral beabstandet zueinander angeordnet und durch das zumindest eine elektrisch isolierende Verbindungselement mechanisch miteinander verbunden. Beispielsweise können die Vollkörper an ihren Seitenflächen in das elektrisch isolierende Verbindungselement eingebettet sein. Die elektrisch leitenden Vollkörper sind dann an ihrer dem aktiven Bereich zugewandten Deckfläche und ihrer dem aktiven Bereich abgewandten Bodenfläche frei vom elektrisch isolierenden Verbindungselement. Das heißt, die Vollkörper können sich insbesondere vollständig durch den Anschlussträger erstrecken und sind an der Oberseite und der Unterseite des Anschlussträgers frei zugänglich.

Die elektrisch leitenden Vollkörper sind beispielsweise mit einem Metall gebildet oder bestehen aus einem Metall. Das zumindest eine elektrisch isolierende Verbindungselement kann mit einem Glas, einem keramischen Material oder einem Kunststoffmaterial gebildet sein.

Die elektrisch leitenden Vollkörper stehen mit den elektrischen Anschlussstellen des Anschlussträgers vorzugsweise in direktem Kontakt oder jede elektrische Anschlussstelle des Anschlussträgers ist durch einen Bereich eines elektrisch leitenden Vollkörpers des Anschlussträgers gebildet. Ferner stehen die elektrisch leitenden Vollkörper mit den Elektroden zur Kontaktierung des aktiven Bereichs in elektrisch leitendem Kontakt, insbesondere in direktem Kontakt, wobei zumindest eine der Elektroden auch durch einen der Vollkörper gebildet sein kann.

Gemäß zumindest einer Ausführungsform des elektronischen Bauteils sind die elektrischen Anschlussstellen an einer der Deckfläche abgewandten Bodenfläche und/oder an einer zur Deckfläche quer verlaufenden Seitenfläche des Anschlussträgers ausgebildet. Beispielsweise können die elektrischen Anschlussstellen durch die dem aktiven Bereich abgewandten Bodenflächen der elektrisch leitenden Vollkörper gebildet sein. Ferner ist es möglich, dass die elektrisch leitenden Vollkörper zumindest an einer Seitenfläche des Anschlussträgers hinausragen und dort als Stifte oder Buchsen für eine Steckkontaktierung ausgebildet sind. Die Stifte oder Buchsen können aber auch in zumindest einen der Vollkörper eingelassen sein, so dass kein Element an der Seitenfläche des Bauteils übersteht.

Das heißt, die elektrisch leitenden Vollkörper des Anschlussträgers bilden dann seitlich Kontaktkörper aus, die entsprechend der elektrischen Polarität kodiert sein und/oder eine Rastfunktion enthalten und/oder nach unten, zur Bodenfläche des Anschlussträgers und/oder nach oben, zur Deckfläche des Anschlussträgers gebogen sein können.

Je nach dem Material, welches zur Bildung des elektrisch isolierenden Verbindungselements Verwendung findet, kann der Anschlussträger flexibel oder starr ausgebildet sein. Der Anschlussträger ist insbesondere nicht zum Strahlungsaustritt oder Strahlungseintritt vorgesehen und kann daher insbesondere auch reflektierend ausgebildet sein. Dazu kann ein Grundmaterial des elektrisch isolierenden Verbindungselements beispielsweise mit strahlungsreflektierenden oder strahlungsstreuenden Partikeln, zum Beispiel aus Titandioxid, gefüllt sein. Das elektrisch isolierende Verbindungselement kann dann zum Beispiel weiß erscheinen. Die elektrisch leitenden Vollkörper können mit einem reflektierenden Material, insbesondere einem reflektierenden Metall, gebildet sein. Darüber hinaus ist es möglich, dass der Anschlussträger an seiner dem aktiven Bereich zugewandten Deckfläche eine reflektierende Beschichtung aufweist oder, dass auf den Anschlussträger zwischen dem aktiven Bereich und dem Anschlussträger eine reflektierende Schicht ausgebildet ist. Die reflektierende Schicht kann auch die Funktion einer Elektrode zum elektrischen Anschließen des aktiven Bereichs übernehmen.

Gemäß zumindest einer Ausführungsform des elektronischen Bauteils sind die elektrischen Anschlussstellen über eine Steckverbindung elektrisch kontaktierbar. Insbesondere ist es möglich, dass die elektrischen Anschlussstellen als Steckverbindung ausgebildet sind. Unterschiedliche Polaritäten der elektrischen Anschlussstellen können durch eine unterschiedliche Ausführung der Steckverbindung kodiert sein, so dass ein Anschließen des elektronischen Bauteils mit falscher Polarität über die Steckverbindung nicht möglich ist. Beispielsweise können die Steckverbindungen durch entsprechend ausgebildete Bereiche der elektrisch leitenden Vollkörper des Anschlussträgers gebildet sein.

Erfindungsgemäß grenzt der aktive Bereich stellenweise direkt an den Anschlussträger und ist mit dem Anschlussträger direkt elektrisch leitend verbunden. In dieser Ausführungsform stellt der Anschlussträger eine Elektrode des aktiven Bereichs dar. Das heißt, zwischen Anschlussträger und aktivem Bereich ist dann stellenweise kein weiteres Material angeordnet, sondern der aktive Bereich wird durch den Anschlussträger direkt bestromt. Der aktive Bereich grenzt dann stellenweise direkt an die Deckfläche des Anschlussträgers.

Dazu kann beispielsweise einer der elektrisch leitenden Vollkörper in direktem Kontakt mit dem aktiven Bereich stehen. Dieser elektrisch leitende Vollkörper kann eine dem aktiven Bereich zugewandte Deckfläche aufweisen, deren Flächeninhalt wenigstens 50 %, insbesondere wenigstens 75 % der Querschnittsfläche des aktiven Bereichs entspricht. Das heißt, der aktive Bereich wird in dieser Ausführungsform über den Vollkörper großflächig bestromt. Diese Ausführungsform ist insbesondere im Hinblick auf eine gute Entwärmung des aktiven Bereichs im Betrieb des elektronischen Bauteils vorteilhaft. Über den elektrisch leitenden Vollkörper kann effizient ein großer Teil der im Betrieb erzeugten Wärme abgeführt werden.

Gemäß zumindest einer Ausführungsform des elektronischen Bauteils ist eine elektrisch isolierende Pufferschicht stellenweise zwischen dem aktiven Bereich und der Deckfläche des Anschlussträgers angeordnet. Die elektrisch isolierende Pufferschicht kann Bereiche der elektrisch leitenden Vollkörper sowie des elektrisch isolierenden Verbindungselements überdecken und mit diesen auch in direktem Kontakt stehen. Die Pufferschicht kann mit dem Anschlussträger an dessen Deckfläche stellenweise in direktem Kontakt stehen. Die Pufferschicht kann dabei verkapselnde Eigenschaften aufweisen und die aktive Schicht vor Feuchtigkeit und atmosphärischen Gasen schützen. Weiter kann die Pufferschicht auch planarisierende Funktionen haben, das heißt, sie kann eventuelle Unebenheiten an der Deckfläche des Anschlussträgers ausgleichen. In einer Ausführungsform, in der der aktive Bereich stellenweise direkt an den Anschlussträger grenzt, kann die Pufferschicht in diesem Bereich eine Aussparung aufweisen oder nicht vorhanden sein, so dass beispielsweise einer der elektrisch leitenden Vollkörper eine Elektrode zur Kontaktierung des aktiven Bereichs darstellen kann.

Gemäß zumindest einer Ausführungsform des elektronischen Bauteils ist die Pufferschicht eine ALD-Schicht oder die Pufferschicht umfasst eine ALD-Schicht. Für den Fall, dass die Pufferschicht eine ALD-Schicht ist, ist sie besonders gut zum Schutz der aktiven Schicht vor Feuchtigkeit und atmosphärischen Gasen geeignet.

Gemäß zumindest einer Ausführungsform des elektronischen Bauteils ist die Verkapselungsschicht eine ALD-Schicht oder die Verkapselungsschicht umfasst eine ALD-Schicht. Dabei ist es insbesondere möglich, dass die Verkapselungsschicht und die Pufferschicht gleichartig aufgebaut sind. Das heißt, die Verkapselungsschicht und die Pufferschicht können beispielsweise die gleiche Abfolge unterschiedlicher Schichten umfassen. Insbesondere können Pufferschicht und Verkapselungsschicht mehrere Schichten und insbesondere mehrere ALD-Schichten umfassen, die übereinander gestapelt angeordnet sind.

Gemäß zumindest einer Ausführungsform des elektronischen Bauteils umfasst das Bauteil eine zweite Elektrode, die den aktiven Bereich und die zweite elektrische Anschlussstelle elektrisch leitend miteinander verbindet, wobei die zweite Elektrode zwischen dem Anschlussträger und dem aktiven Bereich angeordnet ist und die erste Elektrode an der dem Anschlussträger abgewandten Seite des aktiven Bereichs angeordnet ist. Die erste Elektrode ist dabei zumindest stellenweise strahlungsdurchlässig ausgebildet, so dass durch die erste Elektrode im Betrieb zu erzeugende oder zu empfangende elektromagnetische Strahlung treten kann.

Die zweite Elektrode kann beispielsweise zwischen dem Anschlussträger und dem aktiven Bereich angeordnet sein und den aktiven Bereich an seiner dem Anschlussträger zugewandten Bodenfläche möglichst vollständig oder vollständig bedecken. Die zweite Elektrode kann dabei strahlungsreflektierend ausgebildet sein, so dass sie zur Reflexion vom im aktiven Bereich zu erzeugender oder zu detektierender elektromagnetischer Strahlung eingerichtet ist.

Gemäß zumindest einer Ausführungsform des elektronischen Bauteils umfasst das Bauteil zumindest eine Durchkontaktierung durch die Pufferschicht, in der zumindest eine der Elektroden die Pufferschicht durchdringt. Das heißt, die Pufferschicht ist an zumindest einer Stelle geöffnet und das Material zumindest einer Elektrode durchdringt die Pufferschicht in der Öffnung. Beispielsweise ist es auf diese Weise möglich, dass die Pufferschicht die dem aktiven Bereich zugewandte Deckfläche des Anschlussträgers vollständig bedeckt und nur im Bereich der Durchkontaktierungen Öffnungen zum Anschlussträger hin aufweist. Die Durchkontaktierungen durch die Pufferschicht können beispielsweise durch Laserablation hergestellt werden.

Gemäß zumindest einer Ausführungsform des elektronischen Bauteils ist der aktive Bereich abgesehen von den Durchkontaktierungen durch die Pufferschicht vollständig von ALD-Schichten umschlossen. In dieser Ausführungsform umfasst das elektronische Bauteil eine Pufferschicht sowie eine Verkapselungsschicht, die jeweils zumindest eine ALD-Schicht enthalten. Die Pufferschicht und die Verkapselungsschicht grenzen beispielsweise an den Seiten des Bauteils auf dem Anschlussträger direkt aneinander. Die Pufferschicht bedeckt den Anschlussträger abgesehen von den Durchkontaktierungen zu den Elektroden hin vollständig und die Verkapselungsschicht bedeckt die dem Anschlussträger abgewandte Oberfläche der restlichen Komponenten des Bauteils vollständig. Auf diese Weise ist der aktive Bereich, der ein organisches Material enthält, vollständig von ALD-Schichten umgeben. Ein solches Bauteil zeichnet sich durch eine besonders hohe Lebensdauer aus, da der aktive Bereich besonders gut gegen Feuchtigkeit und atmosphärische Gase geschützt ist.

Gemäß zumindest einer Ausführungsform des elektronischen Bauteils sind die elektrisch leitenden Vollkörper des Anschlussträgers verbindungsmittelfrei mit dem zumindest einen elektrisch isolierenden Verbindungselement verbunden. Die Vollkörper können beispielsweise durch Spritzgießen mit dem zumindest einen elektrisch isolierenden Verbindungselement verbunden sein, so dass zwischen den Vollkörpern und dem zumindest einen Verbindungselement kein weiteres Verbindungsmaterial angeordnet ist. Alternativ kann ein Kleben oder Ansintern des zumindest einen elektrisch isolierenden Verbindungsmaterials erfolgen.

Gemäß zumindest einer Ausführungsform des elektronischen Bauteils ist der Anschlussträger als Folie ausgebildet. Beispielsweise kann es sich bei dem Anschlussträger um eine Kombination von Metall und Kunststofffolien handeln. Auf diese Weise kann der Anschlussträger besonders dünn und flexibel ausgebildet sein.

Gemäß zumindest einer Ausführungsform des elektronischen Bauteils weist das elektronische Bauteil an seinen Seitenflächen Vereinzelungsspuren auf. Beispielsweise können eine Vielzahl elektronischer Bauteile auf einem Anschlussträgerverbund gleichzeitig prozessiert werden. Nach dem Herstellen der Verkapselung durch Aufbringen der Verkapselungsschicht kann ein Vereinzeln in einzelne elektronische Bauteile durch die Verkapselungsschicht und den Anschlussträger hindurch erfolgen. In diesem Fall weist zumindest der Anschlussträger an den Seitenflächen des Bauteils Spuren eines Vereinzelungsprozesses, zum Beispiel eines Lasertrennens, auf. Ferner können durch den Trennprozess an den Seitenflächen des Anschlussträgers als Buchsen oder Stecker ausgeführte Anschlussstellen ausgeformt werden, die über eine Steckverbindung elektrisch kontaktierbar sind.

Insbesondere bilden die elektrisch leitenden Vollkörper stellenweise die Außenfläche des elektronischen Bauteils aus. Das heißt, das elektronische Bauteil ist im Bereich des Anschlussträgers seitlich durch die elektrisch leitenden Vollkörper begrenzt.

Im Folgenden wird das hier beschriebene elektronische Bauteil anhand von Ausführungsbeispielen und den dazugehörigen Figuren näher erläutert.

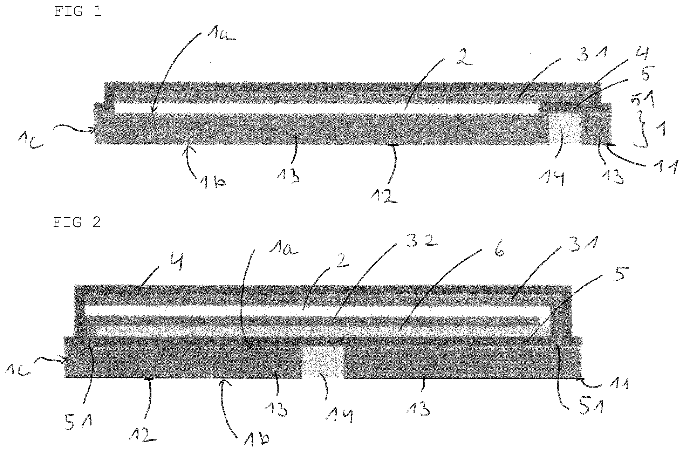

Anhand der schematischen Schnittdarstellung der Figur 1 ist ein Ausführungsbeispiel eines hier beschriebenen elektronischen Bauteils näher erläutert. Figur 2 zeigt ein Vergleichsbeispiel eines elektronischen Bauteils.

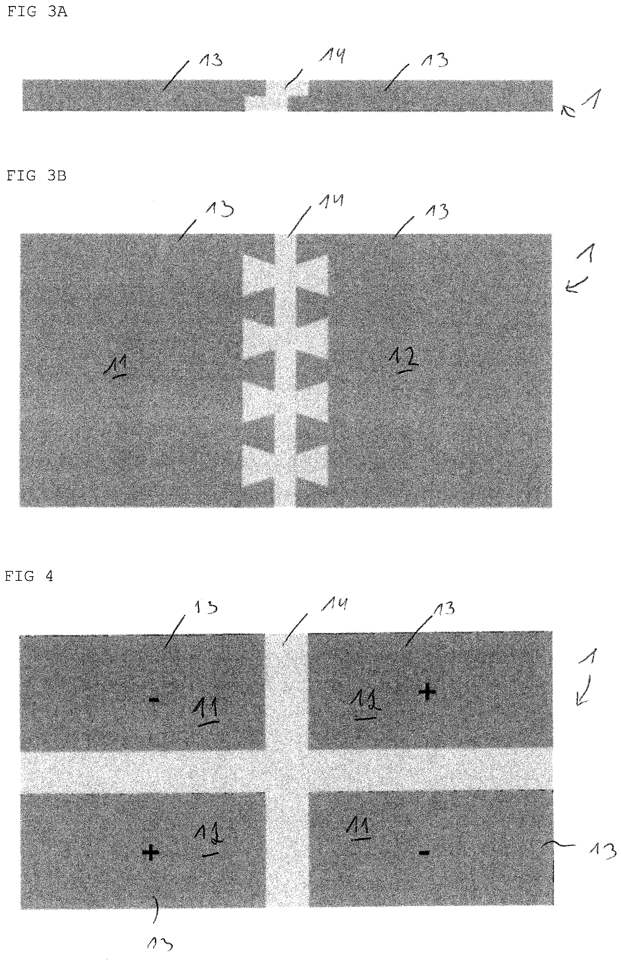

Anhand der schematischen Schnittdarstellungen und Aufsichten auf Anschlussträger von hier beschriebenen elektronischen Bauteilen gemäß der Figuren 3A, 3B, 4 und 5 sind weitere Ausführungsbeispiele von hier beschriebenen elektronischen Bauteilen näher erläutert.

Gleiche, gleichartige oder gleich wirkende Elemente sind in den Figuren mit den gleichen Bezugszeichen versehen. Die Figuren und die Größenverhältnisse der in den Figuren dargestellten Elemente untereinander sind nicht als maßstäblich zu betrachten. Vielmehr können einzelne Elemente zur besseren Darstellbarkeit und/oder für eine bessere Verständlichkeit übertrieben groß dargestellt sein.

Die schematische Schnittdarstellung der Figur 1 zeigt ein Ausführungsbeispiel eines hier beschriebenen elektronischen Bauteils. Das elektronische Bauteil umfasst einen Anschlussträger 1. Der Anschlussträger 1 umfasst eine Deckfläche 1a, eine Bodenfläche 1b sowie die Deckfläche und die Bodenfläche verbindende Seitenflächen 1c.

Im vorliegenden Ausführungsbeispiel umfasst der Anschlussträger zwei elektrisch leitende Elemente, die vorliegend als elektrisch leitende Vollkörper 13 ausgebildet sind. Die elektrisch leitenden Vollkörper 13 bestehen beispielsweise aus einem Metall. An den Unterseiten der elektrisch leitenden Vollkörper 13 sind die erste Anschlussstelle 11 und die zweite Anschlussstelle 12 angeordnet. Über die beiden Anschlussstellen kann das elektronische Bauteil von außerhalb kontaktiert werden. Im Ausführungsbeispiel der Figur 1 wäre beispielsweise eine Oberflächenmontage (englisch: *surface-mounting technology, SMT)* durch eine Oberflächenmontagetechnik möglich.

Die beiden elektrisch leitenden Vollkörper 13 sind vorliegend durch ein elektrisch isolierendes Verbindungselement 14 miteinander verbunden, das beispielsweise mit einem Kunststoff wie einem Epoxidharz oder einem Silikon gebildet ist, welches durch Spritzgießen verbindungsmittelfrei mit den elektrisch leitenden Vollkörpern 13 verbunden ist.

Das elektronische Bauteil weist ferner einen aktiven Bereich 2 auf, der ein organisches Material umfasst. Das Bauteil kann zum Beispiel zur Strahlungserzeugung oder zum Strahlungsempfang vorgesehen sein, wobei die Strahlung im aktiven Bereich 2 erzeugt beziehungsweise empfangen wird. Bei dem Bauteil handelt es sich dann beispielsweise um eine organische Leuchtdiode oder um eine organische Fotodiode.

Das elektronische Bauteil umfasst weiter eine erste Elektrode 31. Die erste Elektrode 31 ist mit einem der elektrisch leitenden Vollkörper 13 sowie der ersten Anschlussstelle 11 elektrisch leitend verbunden und steht beispielsweise in direktem Kontakt mit einem elektrisch leitenden Vollkörper 13. Zwischen der ersten Elektrode 31 und dem Anschlussträger 1 ist zumindest im Bereich des elektrisch isolierenden Verbindungselements 14 eine Pufferschicht 5 angeordnet, die elektrisch isolierend ist.

Die Pufferschicht 5 kann durch Aufdrucken und/oder eine Abscheidetechnik erzeugt werden. Insbesondere kann die Pufferschicht 5 zumindest eine ALD-Schicht umfassen. Die Pufferschicht 5 überdeckt das elektrisch isolierende Verbindungselement 14 vollständig und überdeckt auch den

Übergang zwischen elektrisch isolierendem Verbindungselement 14 und elektrisch leitenden Vollkörpern 13. Auf diese Weise kann die Pufferschicht 5, insbesondere wenn sie zumindest eine ALD-Schicht enthält, mögliche undichte Stellen zwischen den elektrisch leitenden Vollkörpern 13 und dem elektrisch isolierenden Verbindungselement 14 abdichten, da der Verbindungsbereich zwischen diesen beiden Elementen vollständig bedeckt ist.

Die Pufferschicht 5 weist zumindest eine Durchkontaktierung 51 auf, durch die sich die erste Elektrode hindurch erstreckt. Die erste Elektrode 31 verläuft von der Durchkontaktierung 51 aus über die Pufferschicht 5 sowie den aktiven Bereich 2 und bedeckt diesen an seiner dem Anschlussträger 1 abgewandten Deckfläche zum Beispiel vollständig. Die erste Elektrode 31 kann dazu zumindest teilweise strahlungsdurchlässig ausgebildet sein.

Die Pufferschicht 5 ist im Ausführungsbeispiel der Figur 1 optional. Zum Beispiel ist es alternativ auch möglich, dass die Pufferschicht 5 nicht vorhanden ist und sich der aktive Bereich 2 auch dorthin erstreckt, wo in der Figur 1 die Pufferschicht 5 gezeigt ist.

Im Ausführungsbeispiel der Figur 1 grenzt der aktive Bereich 2 mit seiner dem Anschlussträger 1 zugewandten Bodenfläche direkt an einen Vollkörper 13, der auf diese Weise die zweite Elektrode für den elektrischen Anschluss des aktiven Bereichs 2 bildet. Beispielsweise kann der Vollkörper 13 dazu strahlungsreflektierend ausgebildet sein. In diesem Ausführungsbeispiel ist eine besonders einfache großflächige Kontaktierung bei guter Wärmeableitung des aktiven Bereichs 2 möglich.

Das elektronische Bauteil umfasst ferner eine Verkapselungsschicht 4, welche zumindest eine ALD-Schicht enthalten kann. Die Verkapselungsschicht 4 grenzt stellenweise an den Anschlussträger 1. Der aktive Bereich 2 wird durch die Verkapselungsschicht 4 vor Feuchtigkeit und atmosphärischen Gasen geschützt.

Im Vergleichsbeispiel der Figur 2 bedeckt die Pufferschicht 5 im Unterschied zum Ausführungsbeispiel der Figur 1 den Anschlussträger 1 an seiner Deckfläche fast vollständig und ist nur von den Durchkontaktierungen 51 zur Kontaktierung der Elektroden 31, 32 durchbrochen. Die Verkapselungsschicht 4 und die Pufferschicht 5 grenzen an der Deckfläche 1a des Anschlussträgers im Randbereich des Bauteils direkt aneinander, so dass abgesehen von den Durchkontaktierungen 51 der aktive Bereich 2 vollständig von der Pufferschicht 5 und der Verkapselungsschicht 4 umschlossen ist. In diesem Vergleichsbeispiel ist es insbesondere möglich, dass die Pufferschicht 5 und die Verkapselungsschicht 4 zumindest eine ALD-Schicht enthalten oder aus zumindest einer ALD-Schicht bestehen.

Im Vergleichsbeispiel der Figur 2 ist ferner eine zweite Elektrode 32 vorhanden, welche an der dem Anschlussträger 1 abgewandten Unterseite des aktiven Bereichs 2 angeordnet ist. Die zweite Elektrode 32 ist dabei zum Beispiel zumindest stellenweise strahlungsreflektierend ausgebildet. Zwischen der zweiten Elektrode 32 und dem Anschlussträger 1 kann auf der Pufferschicht 5 eine elektrisch isolierende Planarisierungsschicht 6 angeordnet sein, die die Pufferschicht 5 vollständig bedeckt und Unebenheiten des Anschlussträgers 1 und/oder der Pufferschicht 2 ausgleicht.

Die Planarisierungsschicht 6 ist dabei optional und kann gegebenenfalls auch Teil der Pufferschicht 5 sein.

In Verbindung mit den Figuren 3A und 3B ist anhand einer schematischen Schnittdarstellung sowie einer schematischen Aufsicht ein Ausführungsbeispiel für einen Anschlussträger eines hier beschriebenen elektronischen Bauteils gezeigt. Die Vollkörper 13 sind in diesem Ausführungsbeispiel durch ein elektrisch isolierendes Verbindungselement 14 miteinander verbunden, welches durch eine Strukturierung der Vollkörper 13 an den einander zugewandten Seitenflächen mit den Vollkörpern 13 verzahnt ist. Das elektrisch isolierende Verbindungselement 14 kann dabei beispielsweise durch ein Spritzgussverfahren mit den Vollkörpern 13, also den elektrisch leitenden Elementen des Anschlussträgers verbunden sein.

In Verbindung mit der Figur 4 ist eine Ausgestaltung des Anschlussträgers 1 beschrieben, bei dem eine verpolungssichere Kontaktanordnung der Anschlussstellen 11, 12 gewährleistet ist. Das elektrisch isolierende Verbindungselement 14 ist dabei in der Draufsicht kreuzförmig angeordnet und erste und zweite Anschlussstellen 11, 12 sind an der Unterseite des Anschlussträgers 1 in diagonalen Quadranten des durch das Verbindungselement gebildeten Kreuzes angeordnet.

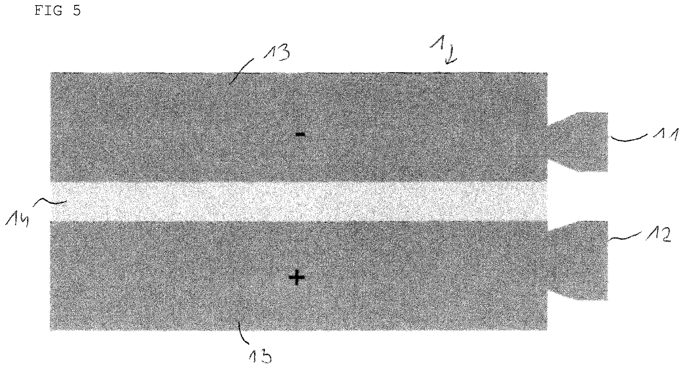

In Verbindung mit der Figur 5 ist anhand einer schematischen Draufsicht ein Ausführungsbeispiel eines hier beschriebenen elektronischen Bauteils beschrieben, bei dem an den Seitenflächen der Vollkörper 13 erste und zweite elektrische Anschlussstellen 11, 12 in Form von Kontaktkörpern ausgebildet sind. Bei den Kontaktkörpern kann es sich beispielsweise um Stecker oder Buchsen handeln, die für die unterschiedliche Polung der Anschlussstellen unterschiedlich ausgebildet sind, so dass eine verpolungssichere Anordnung der Anschlussstellen gegeben ist.

Diese Patentanmeldung beansprucht die Priorität der deutschen Patentanmeldung 102013113190.5.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Elektronisches Bauteil mit
- einem Anschlussträger (1) umfassend eine Deckfläche (la), eine erste elektrische Anschlussstelle (11) und eine zweite elektrische Anschlussstelle (12),
- einem organischen, aktiven Bereich (2) an der Deckfläche (1a) ,
- einer ersten Elektrode (31), die den aktiven Bereich (2) und die erste elektrische Anschlussstelle (11) elektrisch leitend miteinander verbindet,
- einer Verkapselungsschicht (4), die den aktiven Bereich (2) vor Feuchtigkeit und atmosphärischen Gasen schützt, wobei
- das elektronische Bauteil über die elektrischen Anschlussstellen (11, 12) von außen kontaktierbar ist, und
- der Anschlussträger (1) mit wenigstens zwei elektrisch leitenden Vollkörper (13) gebildet ist, die durch zumindest ein elektrisch isolierendes Verbindungselement (14) miteinander verbunden sind, **dadurch gekennzeichnet, dass**
- die Verkapselungsschicht (4) stellenweise mit dem Anschlussträger (1) in direktem Kontakt steht, und
- der aktive Bereich (2) stellenweise direkt an den Anschlussträger (1) grenzt und mit dem Anschlussträger (1) direkt elektrisch leitend verbunden ist.

2. Elektronisches Bauteil nach dem vorherigen Anspruch, bei dem die elektrischen Anschlussstellen (11, 12) an einer der Deckfläche (1a) abgewandten Bodenfläche (1b) und/oder an einer zur Deckfläche (1a) quer verlaufenden Seitenflächen (1c) des Anschlussträger (1) ausgebildet sind.

3. Elektronisches Bauteil nach einem der vorherigen Ansprüche,
bei dem die elektrischen Anschlussstellen (11, 12) über eine Steckverbindung elektrisch kontaktierbar sind.

4. Elektronisches Bauteil nach einem der vorherigen Ansprüche
mit einer elektrisch isolierenden Pufferschicht (5), die stellenweise zwischen dem aktiven Bereich (2) und der Deckfläche (1a) des Anschlussträgers (1) angeordnet ist.

5. Elektronisches Bauteil nach dem vorherigen Anspruch, bei dem die Pufferschicht (5) die aktive Schicht vor Feuchtigkeit und atmosphärischen Gasen schützt.

6. Elektronisches Bauteil nach einem der beiden vorherigen Ansprüche,
bei dem die Pufferschicht (5) eine ALD-Schicht ist oder eine ALD-Schicht umfasst.

7. Elektronisches Bauteil nach einem der vorherigen Ansprüche,
bei dem die Verkapselungsschicht (4) eine ALD-Schicht ist oder eine ALD-Schicht umfasst.

8. Elektronisches Bauteil nach einem der vorherigen Ansprüche
mit einer zweiten Elektrode (32), die den aktiven Bereich (2) und die zweite elektrische Anschlussstelle (12) elektrisch leitend miteinander verbindet, wobei die zweite Elektrode (32) zwischen dem Anschlussträger (1) und dem aktiven Bereich (2) angeordnet ist und die erste Elektrode (11) an der dem Anschlussträger (1) abgewandten Seite des aktiven Bereichs (2) angeordnet ist.

9. Elektronisches Bauteil nach einem der Ansprüche 4-8 mit zumindest einer Durchkontaktierung (51) durch die Pufferschicht, in der zumindest eine der Elektroden (31, 32) die Pufferschicht durchdringt.

10. Elektronisches Bauteil nach einem der vorherigen Ansprüche,
bei dem der aktive Bereich (2) abgesehen von den Durchkontaktierungen (51) durch die Pufferschicht (5) vollständig von ALD-Schichten umschlossen ist.

11. Elektronisches Bauteil nach einem der vorherigen Ansprüche,
bei dem der aktive Bereich (2) zum Erzeugen und/oder zum Empfangen von elektromagnetischer Strahlung vorgesehen ist.

## Claims

1. Electronic device with
- a connection carrier (1) comprising a cover surface (1a), a first electric connection point (11) and a second electric connection point (12),
- an organic, active area (2) on the cover surface (1a),
- a first electrode (31) which connects the active area (2) and the first electric connection point (11) with each other in an electrically conductive manner,
- an encapsulation layer (4) which protects the active area (2) against humidity and atmospheric gases, wherein
- the electronic device is contactable from outside via the electric connection points (11, 12), and
- the connection carrier (1) is formed with at least two electrically conductive solid bodies (13), which are connected with each other by at least one electrically insulating connecting element (14),
**characterized in that**
- the encapsulation layer (4) is in direct contact with the connection carrier (1) in places, and
- the active area (2) is directly adjacent to the connection carrier (1) in places and is directly connected with the connection carrier (1) in an electrically conductive manner.

2. Electronic device according to the preceding claim,
in which the electric connection points (11, 12) are formed on a bottom surface (1b) facing away from the cover surface (1a) and/or on a side surface (1c) of the connection carrier (1) extending transversely to the cover surface (1a).

3. Electronic device according to one of the preceding claims,
in which the electric connection points (11, 12) are electrically contactable via a plug connection.

4. Electronic device according to one of the preceding claims,
with an electronically insulating buffer layer (5), which is arranged between the active area (2) and the cover surface (1a) of the connection carrier (1) in places.

5. Electronic device according to the preceding claim,
in which the buffer layer (5) protects the active layer against humidity and atmospheric gases.

6. Electronic device according to one of the two preceding claims,
in which the buffer layer (5) is an ALD layer or comprises an ALD layer.

7. Electronic device according to one of the preceding claims,
in which the encapsulation layer (4) is an ALD layer or comprises an ALD layer.

8. Electronic device according to one of the preceding claims,
with a second electrode (32) which connects the active area (2) and the second electrical connection point (12) with each other in an electrically conductive manner, wherein the second electrode (32) is arranged between the connection carrier (1) and the active area (2) and the first electrode (11) is arranged on the side of the active area (2) facing away from the connection carrier (1).

9. Electronic device according to one of the claims 4-8, with at least one through connection (51) through the buffer layer, in which at least one of the electrodes (31, 32) permeates the buffer layer.

10. Electronic device according to one of the preceding claims,
in which the active area (2) is completely encompassed by ALD layers, aside from the through connections (51) through the buffer layer (5).

11. Electronic device according to one of the preceding claims,
in which the active area (2) is configured for generating and/or receiving electromagnetic radiation.

## Revendications

1. Composant électronique avec
- un support de connexion (1) comprenant une surface supérieure (la), un premier point de connexion électrique (11) et un second point de connexion électrique (12),
- une région active organique (2) sur la surface supérieure (1a) ,
- une première électrode (31) reliant de manière électriquement conductrice la région active (2) et le premier point de connexion électrique (11) l'un à l'autre,
- une couche d'encapsulation (4) qui protège la région active (2) de l'humidité et des gaz atmosphériques, dans lequel
- le composant électronique est contactable de l'extérieur via les points de connexion électrique (11, 12), et
- le support de connexion (1) est formé d'au moins deux corps solides (13) électriquement conducteurs qui sont reliés entre eux par au moins un élément de connexion (14) électriquement isolant, **caractérisé en ce que**
- la couche d'encapsulation (4) est en contact direct avec le support de connexion (1) par endroits, et
- la région active (2) est par endroits directement adjacente au support de connexion (1) et est directement reliée de manière électriquement conductrice au support de connexion (1) .

2. Composant électronique selon la revendication précédente, dans lequel les points de connexion électrique (11, 12) sont formés sur une surface inférieure (1b) opposée à la surface supérieure (1a) et/ou sur une surface latérale (1c) du support de connexion (1) s'étendant transversalement à la surface supérieure (1a).

3. Composant électronique selon l'une des revendications précédentes,
dans lequel les points de connexion électrique (11, 12) sont contactables électriquement par une connexion enfichable.

4. Composant électronique selon l'une des revendications précédentes
avec une couche tampon (5) électriquement isolante qui est disposée par endroits entre la région active (2) et la surface supérieure (1a) du support de connexion (1).

5. Composant électronique selon la revendication précédente, dans lequel la couche tampon (5) protège la couche active de l'humidité et des gaz atmosphériques.

6. Composant électronique selon l'une ou l'autre des deux revendications précédentes,
dans lequel la couche tampon (5) est une couche ALD ou comprend une couche ALD.

7. Composant électronique selon l'une des revendications précédentes,
dans lequel la couche d'encapsulation (4) est une couche ALD ou comprend une couche ALD.

8. Composant électronique selon l'une des revendications précédentes
avec une deuxième électrode (32) qui relie de manière électriquement conductrice la région active (2) et le deuxième point de connexion électrique (12) l'un à l'autre, dans lequel la deuxième électrode (32) est disposée entre le support de connexion (1) et la région active (2), et la première électrode (11) est disposée sur le côté de la région active (2) qui est opposé au support de connexion (1).

9. Composant électronique selon l'une des revendications 4 à 8 avec au moins un trou d'interconnexion (51) à travers la couche tampon, dans lequel au moins une des électrodes (31, 32) pénètre dans la couche tampon.

10. Composant électronique selon l'une des revendications précédentes,
dans lequel la région active (2) est complètement entourée de couches ALD, à l'exception des trous d'interconnexion (51) traversant la couche tampon (5).

11. Composant électronique selon l'une des revendications précédentes,
dans lequel la région active (2) est prévue pour générer et/ou recevoir un rayonnement électromagnétique.
